# EUROPÄISCHE PATENTSCHRIFT

(11) **EP 1 929 635 B1**
(45) Veröffentlichungstag und Bekanntmachung des Hinweises auf die Patenterteilung: **24.12.2014**
(21) Anmeldenummer: 06805352.9
(22) Anmeldetag: 29.09.2006
(51) Int. Cl.: H03M 3/00

(54) **SCHALTUNGSANORDNUNG UND VERFAHREN ZUM AUSLESEN EINES SENSORS MIT EINEM SIGMA-DELTA-WANDLER**
CIRCUIT AND METHOD FOR SENSOR READINGS BY MEANS OF A SIGMA-DELTA CONVERTER
CIRCUIT ET PROCEDE D'EXTRACTION DE DONNEES D'UN CAPTEUR AU MOYEN D'UN CONVERTISSEUR SIGMA-DELTA

(30) Priorität: 29.09.2005 DE 102005046699
(43) Veröffentlichungstag der Anmeldung: 11.06.2008
(73) Patentinhaber: Albert-Ludwigs-Universität Freiburg, 79088 Freiburg (DE)
(72) Erfinder: MANOLI, Yiannos, 79104 Freiburg (DE); BUHMANN, Alexander, 79110 Freiburg (DE)
(74) Vertreter: Gagel, Roland
(86) Internationale Anmeldenummer: PCT/DE2006/001728
(87) Internationale Veröffentlichungsnummer: WO 2007/036224

(56) Entgegenhaltungen:
- SPINEANU A ET AL: "An electromechanical sigma-delta modulator for acceleration measuring systems" CIRCUITS AND SYSTEMS, 1997. ISCAS '97., PROCEEDINGS OF 1997 IEEE INTERNATIONAL SYMPOSIUM ON HONG KONG 9-12 JUNE 1997, NEW YORK, NY, USA,IEEE, US, Bd. 4, 9. Juni 1997 (1997-06-09), Seiten 2765-2768, XP010236302 ISBN: 0-7803-3583-X
- BRACKE W ET AL: "On the optimization of ultra low power front-end interfaces for capacitive sensors" SENSORS AND ACTUATORS A, ELSEVIER SEQUOIA S.A., LAUSANNE, CH, Bd. 117, Nr. 2, 14. Januar 2005 (2005-01-14), Seiten 273-285, XP004587266 ISSN: 0924-4247
- MARK LEMKIN ET AL: "A Three-Axis Micromachined Accelerometer with a CMOS Position-Sense Interface and Digital Offset-Trim Electronics" IEEE JOURNAL OF SOLID-STATE CIRCUITS, IEEE SERVICE CENTER, PISCATAWAY, NJ, US, Bd. 34, Nr. 4, April 1999 (1999-04), XP011060979 ISSN: 0018-9200 in der Anmeldung erwähnt

## Beschreibung

### Technisches Anwendungsgebiet

Die vorliegende Erfindung betrifft eine Schaltungsanordnung zum Auslesen eines Sensors, die einen Sigma-Delta-Wandler mit zumindest einem Schleifenfilter, einem Quantisierer und einem Rückkopplungszweig umfasst, wobei sich in Abhängigkeit von einer auf den Sensor wirkenden Messgröße eine messbare elektrische Eigenschaft des Sensors ändert und der Sensor zwischen dem Rückkopplungszweig und dem Schleifenfilter derart verschaltet ist, dass Rückkopplungssignale des Sigma-Delta-Wandlers im zeitlichen Mittel die Wirkung der Messgröße auf den Sensor kompensieren. Die Erfindung betrifft auch ein zugehöriges Verfahren zum Auslesen eines Sensors unter Einsatz eines Sigma-Delta-Wandlers.

Der Einsatz von Sensoren spielt heutzutage in allen Bereichen der Technik eine große Rolle. Ein sehr wichtiger Bereich der Sensorik betrifft die Messung von Beschleunigungen, die auf einen Körper wirken. Ein bekanntes Beispiel hierfür sind Airbag-Beschleunigungssensoren. Diese messen die Beschleunigung während eines Aufpralles und liefern damit die Entscheidungsgrundlage für das Zünden der Airbags. Ein weiteres Beispiel ist das Inertiale Navigationssystem (INS), das auf Basis von Beschleunigungsdaten und mit Hilfe von GPS (GPS: Global Positioning System) die Position und Rotation eines Objektes bestimmt. Auch bei der Transportüberwachung und beim so genannten Body Monitoring sind Beschleunigungssensoren unabdingbar.

Beschleunigungssensoren nutzen die Wirkung der Beschleunigung auf eine Testmasse für die Bestimmung der Beschleunigung. Dabei nimmt die Klasse der FederMasse-Sensoren, bei denen die Auslenkung einer elastisch aufgehängten Testmasse bestimmt wird, den größten Anteil ein. Die Testmasse stellt hierbei zumindest eine Platte oder Elektrode einer Kondensatoranordnung dar, die sich relativ zu ein oder mehreren stationären Platten oder Elektroden der Kondensatoranordnung bewegen kann. Eine Auslenkung der Testmasse wird dabei über eine Änderung der Kapazität dieser Kondensatoranordnung erfasst. Derartige Beschleunigungssensoren sind häufig in mikromechanischer Bauweise ausgeführt, wobei die einzelnen Elektroden der Kondensatoranordnung beispielsweise durch kammartig ineinander greifende Strukturen realisiert sein können. Als weitere bekannte Klasse von Beschleunigungssensoren sind die in Resonanz befindlichen Systeme zu nennen, die als Beschleunigungsmaß eine Änderung der Resonanzfrequenz liefern.

Bei kommerziell erhältlichen Sensorsystemen, die in der Regel das Auslenkungsprinzip nutzen, erfolgt die Datenverarbeitung seriell. Der Sensor wandelt die zu messende Größe meist über eine Zwischengröße in ein elektrisches Signal. Das elektrische Signal wird dann in einem weiteren Schritt digitalisiert. Dadurch überlagern sich jedoch die Nichtidealitäten der Einzelsysteme und die Gesamtperformance des Systems wird durch das schlechteste Einzelsystem dominiert.

Aus dem Bereich der Forschung ist es neben dieser seriellen Verarbeitung auch bekannt, den Sensor in die Regelungsschleife eines Sigma-Delta-Wandlers einzubinden. Dadurch lassen sich die Gesamteigenschaften des Systems, beispielsweise die Signalbandbreite, stark verbessern. Ein Beispiel für eine derartige Schaltungsanordnung zeigen M. Lemkin et al., "A Three-Axis Micromachined Accelerometer with a CMOS Position-Sense Interface and Digital Offset-Trim Electronics", IEEE Journal of Solid State Circuits, Vol. 34, No. 4, April 1999, Seiten 456-468. Bei der dort gezeigten gattungsgemäßen Schaltungsanordnung wird ein zeitdiskreter Sigma-Delta-Modulator eingesetzt. Zeitdiskrete Modulatoren lassen sich besonders einfach mit kapazitiven Sensoren kombinieren, da sie mit der so genannten Schalter-Kondensator-Technik (SC-Technik) arbeiten. Dabei kann der Sensor eine der vorhandenen festen Kapazitäten eines derartigen Modulators ersetzen. Durch die aktive Rückkopplung in der Schaltungsanordnung wird eine Linearisierung des Sensors erreicht. Die Auslenkung der Testmasse des Sensors durch die Messgröße wird durch diese Rückkopplung im Mittel kompensiert, so dass der Sensor im Idealfall ein verschwindendes Differenzsignal als Eingangssignal erfährt. Das Ausgangssignal des Sigma-Delta-Wandlers stellt somit in digitalisierter Form ein Maß für die Kraft dar, die erforderlich ist, um die Auslenkung der Testmasse durch die einwirkende Beschleunigung zu verhindern.

SPINEANU A ET AL: "An electromechanical sigma-delta modulator for acceleration measuring systems"CIRCUITS AND SYSTEMS, 1997. ISCAS '97., PROCEEDINGS OF 1997 IEEE INTERNATIONAL SYMPOSIUM ON HONG KONG 9-12 JUNE 1997, NEW YORK, NY, USA,IEEE, US, Bd. 4, 9. Juni 1997 (1997-06-09), Seiten 2765-2768, XP010236302 ISBN: 0-7803-3583-X offenbart eine Schaltungsanordnung zum Auslese eines Sensors, die einen Sigma-Delta-Wandler mit zumindest einem Schleifenfilter, einem Quantisierer und einem Rückkopplungszweig umfasst, wobei sich in Abhängigkeit von einer auf den Sensor wirkenden Messgröße eine messbare elektrische Eigenschaft des Sensors ändert und der Sensor zwischen dem Rückkopplungszweig und dem Schleifenfilter derart verschallet ist, dass Rückkopplungssignale des Sigma-Delta-Wandlers im zeitlichen Mittel die Wirkung der Messgröße auf den Sensor kompensieren und dass der Sigma-Delta-Wandler ein zeitkontinuierlicher Sigma-Delta-Wandler ist.

Einen wichtigen Gesichtspunkt beim Einsatz von Sensorsystemen stellt der Leistungsverbrauch dar. So ist eine möglichst lange Verfügbarkeit ohne externe Energiezufuhr gerade im mobilen Bereich, beispielsweise beim Einsatz im Bereich des Body Monitoring, von großer Bedeutung.

Die Aufgabe der vorliegenden Erfindung besteht darin, eine Schaltungsanordnung sowie ein Verfahren zum Auslesen eines Sensors, insbesondere eines kapazitiven Sensors, anzugeben, die einen gegenüber bekannten Lösungen verringerten Leistungsverbrauch ermöglichen.

### Darstellung der Erfindung

Die Aufgabe wird mit der Schaltungsanordnung sowie dem Verfahren gemäß den Patentansprüchen 1 und 11 gelöst. Vorteilhafte Ausgestaltungen der Schaltungsanordnung sowie des Verfahrens sind Gegenstand der Unteransprüche oder lassen sich der nachfolgenden Beschreibung sowie den Ausführungsbeispielen entnehmen.

Die vorliegende Schaltungsanordnung weist in bekannter Weise einen Sigma-Delta-Wandler mit zumindest einem Schleifenfilter, einem Quantisierer und einem Rückkopplungszweig auf, wobei sich in Abhängigkeit von einer auf den Sensor wirkenden Messgröße eine messbare elektrische Eigenschaft des Sensors ändert. Der Sensor ist zwischen dem Rückkopplungszweig und dem Schleifenfilter derart verschaltet, dass Rückkopplungssignale des Sigma-Delta-Wandlers im zeitlichen Mittel die Wirkung der Messgröße auf den Sensor kompensieren. Die vorliegende Schaltungsanordnung zeichnet sich dadurch aus, dass kein zeitdiskreter, sondern ein zeitkontinuierlicher Sigma-Delta-Wandler eingesetzt wird. Durch den Einsatz eines zeitkontinuierlichen Sigma-Delta-Wandlers in der Schaltungsanordnung ist zwar eine geeignete Auswerteschnittstelle zwischen dem Sensor und dem Schleifenfilter erforderlich, die die durch die Messgröße beeinflusste elektrische Eigenschaft des Sensors in ein elektrisches Sensorsignal wandelt. Der Leistungsverbrauch der hierfür erforderlichen zusätzlichen elektrischen Komponenten wird jedoch durch den reduzierten Leistungsverbrauch des zeitkontinuierlichen Sigma-Delta-Wandlers im Vergleich zu einer Schaltungsanordnung mit einem zeitdiskreten Sigma-Delta-Wandler mehr als kompensiert. Durch die Verwendung zeitkontinuierlicher Signale können die im Sigma-Delta-Wandler eingesetzten Operationsverstärker eine bis zu einem Faktor 10 geringere Bandbreite aufweisen als bei Verwendung zeitdiskreter Signale, woraus ein bis zu einem Faktor 10 geringerer Stromverbrauch resultiert. Dies führt zu einem drastisch reduzierten Energieverbrauch, der gerade in dem stark wachsenden Markt der mobilen Sensorik von erheblichem Vorteil ist. Ein weiterer Vorteil der vorliegenden Schaltungsanordnung sowie des zugehörigen Verfahrens besteht darin, dass zeitkontinuierliche Sigma-Delta-Wandler einen impliziten Antialiasing-Filter besitzen, der Frequenzen oberhalb der halben Signalfrequenz (fₛ/2) filtert. Diese Eigenschaft reduziert den Schaltungsaufwand, die Kosten sowie zusätzlich den erforderlichen Stromverbrauch einer derartigen Schaltungsanordnung.

Die vorliegende Schaltungsanordnung sowie das zugehörige Verfahren lassen sich insbesondere mit kapazitiven Sensoren, beispielsweise mit kapazitiven Beschleunigungs- oder Drehratensensoren, einsetzen. Die Schaltungsanordnung und das Verfahren sind jedoch auch zum Auslesen von Sensoren geeignet, die mit anderen Messprinzipien arbeiten, solange die durch die Messgröße auf den Sensor ausgeübte Wirkung durch ein geeignetes elektrisches Rückkopplungssignal kompensierbar ist.

Im Rückkopplungszweig der vorliegenden Schaltungsanordnung wird ein Digital-Analog-Wandler eingesetzt, der die digitalisierten Rückkopplungssignale in analoge Ladungs- oder Spannungssignale wandelt. Hierbei kann es sich um einen 1 Bit Digital-Analog-Wandler oder um einen Multibit Digital-Analog-Wandler, beispielsweise einen 2-4 Bit Wandler, handeln. Die Multibit-Wandlung ist für Sensoren geeignet, die mehrere Kondensatorplatten bzw. Elektroden zur Kompensation bzw. Rückkopplung nutzen. Die Dimensionen der einzelnen Platten des Sensors müssen hierbei gleich groß sein, um eine lineare Rückkopplung zu erreichen.

Durch die Verwendung spezieller Schleifenfilter wird die durch den Sensor vorgegebene Resonanzfrequenz entweder zu höheren Frequenzen verschoben oder vollständig kompensiert. Die Verschiebung zu höheren Frequenzen wird durch den integrierenden Anteil in den ein oder mehreren Schleifenfiltern, insbesondere durch die große Verstärkung des Integrators für kleine Frequenzen, erreicht. Dadurch erweitert sich der nutzbare Signalbereich des Sensors bei einer PI-Regelung. In gleicher Weise lässt sich durch eine geeignete Filterstruktur ein PID-Regler realisieren. Durch Verwendung eines differenzierenden Anteils und einer großen Schleifenverstärkung kann in diesem Fall die Resonanz vollständig kompensiert werden.

In einer besonders vorteilhaften Ausgestaltung der vorliegenden Schaltungsanordnung sowie des zugehörigen Verfahrens wird ein zeitkontinuierlicher Bandpass Sigma-Delta-Wandler eingesetzt. Ein derartiger Wandler reduziert zusätzlich in signifikanter Weise die Anforderungen an die verwendeten Operationsverstärker. Durch eine Modulation des vom Sensor erhaltenen Sensorsignals zu höheren Frequenzen können Nichtidealitäten des Sigma-Delta-Wandlers bzw. dessen elektrischer Bauteile umgangen werden. Die modulierten Signale werden durch den Bandpass Sigma-Delta-Wandler gefiltert. Damit das ganze System funktioniert, müssen die Rückkopplungssignale wieder auf die richtige Frequenz heruntergemischt werden, um das Eingangssignal des Sensors kompensieren zu können. Hierfür ist ein geeigneter Mischer im Rückkopplungszweig vorgesehen. Die Modulation zu höheren Frequenzen erfolgt bei Einsatz kapazitiver Sensoren automatisch, wenn diese in bekannter Weise über Anlegen einer geeigneten Wechselspannung ausgelesen werden.

In einer weiteren sehr vorteilhaften Ausgestaltung der Schaltungsanordnung sowie des Verfahrens wird ebenfalls ein Bandpass Sigma-Delta-Wandler eingesetzt. Auch in dieser Anordnung erfolgt eine Modulation des Sensorsignals zu höheren Frequenzen, für die der Bandpass durchlässig ist. Die modulierten Signale werden dann jedoch durch Sub-Nyquist-Sampling während des Abtast-Prozesses wieder heruntergemischt und damit in situ die Abtastrate reduziert. Dadurch lässt sich die Leistung im Digital-Analog-Wandler, im Analog-Digital-Wandler wie auch im gesamten digitalen Bereich der Schaltungsanordnung reduzieren, da diese Komponenten bei einer niedrigeren Frequenz arbeiten können. Mit dieser Ausgestaltung werden damit der schaltungstechnische Aufwand und die Leistungsaufnahme und somit der Leistungsverbrauch nochmals deutlich reduziert.

### Kurze Beschreibung der Zeichnungen

Die vorliegende Schaltungsanordnung sowie das zugehörige Verfahren werden nachfolgend anhand von Ausführungsbeispielen in Verbindung mit den Zeichnungen nochmals kurz erläutert. Hierbei zeigen:
- Fig. 1: schematisch ein Modell der vorliegenden Schaltungsanordnung;
- Fig. 2: ein Beispiel für ein nutzbares Spektrum eines Beschleunigungssensors in der vorliegenden Schaltungsanordnung;
- Fig. 3: ein weiteres Beispiel für ein nutzbares Spektrum eines Beschleunigungssensors in der vorliegenden Vorrichtung;
- Fig. 4: zwei Beispiele für eine Auswerteschaltung in der vorliegenden Schaltungsanordnung;
- Fig. 5: zwei Beispiele für die Rückkopplung in der vorliegenden Schaltungsanordnung;
- Fig. 6: eine Darstellung zur Veranschaulichung der Betriebsweise der vorliegenden Schaltungsanordnung mit einem Bandpass Sigma-Delta-Wandler; und
- Fig. 7: ein Beispiel für die Unterdrückung unerwünschter Signale bei Einsatz eines Bandpass Sigma-Delta-Wandlers mit Sub-Nyquist-Sampling in der vorliegenden Schaltungsanordnung.

### Wege zur Ausführung der Erfindung

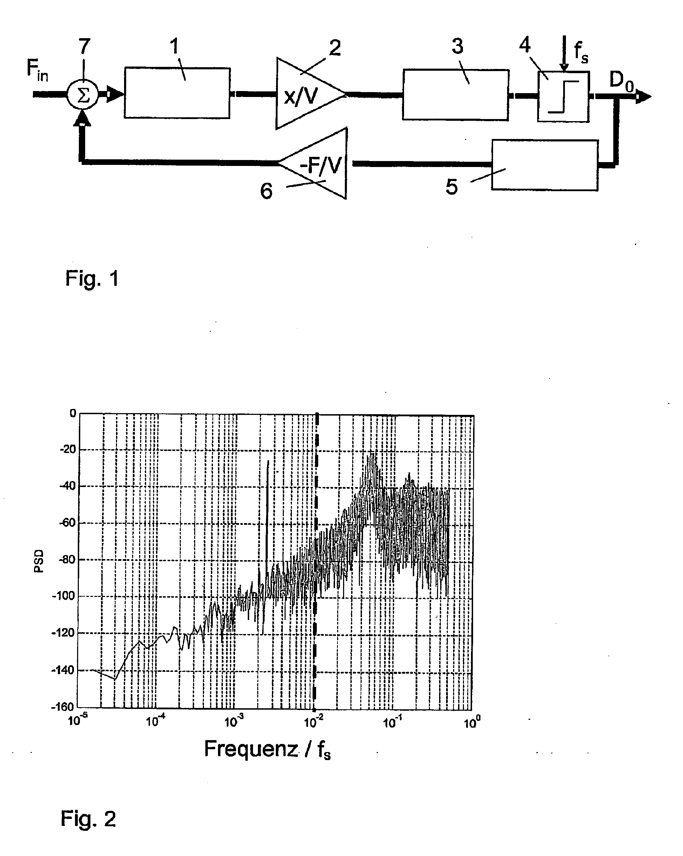

Fig. 1 zeigt beispielhaft ein Modell eines 1 Bit Sigma-Delta-Wandlers, bei dem zwischen dem Rückkopplungszweig und dem Schleifenfilter oder Integrator ein kapazitiver Beschleunigungssensor 1 geschaltet ist. Der Sensor 1 weist in bekannter Weise eine elastisch aufgehängte Testmasse auf, die bei einer einwirkenden Kraft F_{IN} ihre Lage ändert und damit zu einer Änderung der Kapazität des Sensors 1 führt. Das elektrische Sensorsignal wird durch eine Auswerteschaltung 2 erzeugt, die die Auslenkung der Testmasse in ein geeignetes Spannungssignal wandelt. Durch den integrierenden Anteil in der Filterstruktur 3 des zeitkontinuierlichen Sigma-Delta-Wandlers erfolgt eine Verschiebung des Sensorsignals zu höheren Frequenzen. Das Signal wird über den Quantisierer 4 digitalisiert und am Ausgang als digitales Wort bereitgestellt. Durch die Rückkopplung über den Digital-Analog-Wandler 5, die Umsetzung der Rückkopplungssignale in einer geeigneten Kompensationsschaltung 6 und die Addition mit dem Eingangssignal, angedeutet durch den Addierer 7, wird die Wirkung der auf den Sensor 1 einwirkenden Kraft F_{IN} im Mittel kompensiert, so dass der Sensor 1 im Idealfall ein verschwindendes Differenzsignal erfährt. Durch diese Kompensation wird eine vorteilhafte Linearisierung des Sensors erreicht.

Durch die Verwendung spezieller Filterstrukturen 3 kann sowohl eine PI- als auch eine PID-Regelung durchgeführt werden. Im ersten Fall wird durch die große Verstärkung des Integrators der Filterstruktur für kleine Frequenzen die Resonanzfrequenz fᵣₑₛ des Sensors zu höheren Frequenzen verschoben. Dadurch erweitert sich der nutzbare Signalbereich fₛ des Sensors 1, wie dies auch in der Figur 2 zu erkennen ist, in der gestrichelt die ursprüngliche Resonanzfrequenz fᵣₑₛ des Sensors angedeutet ist. Das mechanische System ist in diesem Falle überkritisch gedämpft, um zusätzliche Limitcycles zu unterdrücken. Die effektive Bandbreite konnte in diesem Beispiel durch Wahl geeigneter Filyterkoeffizienten um einen Faktor 5 erhöht werden.

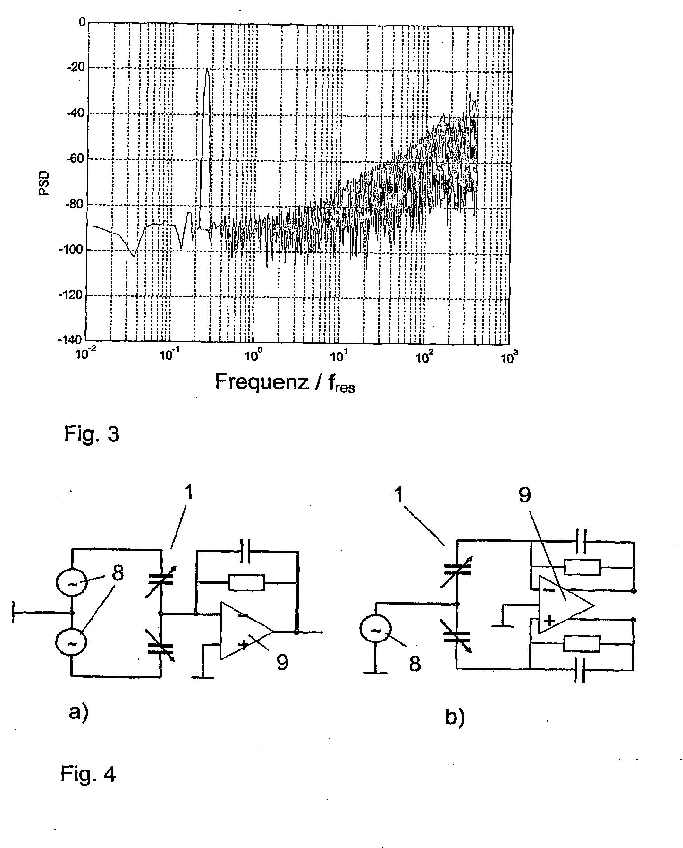

Durch Verwendung eines differenzierenden Anteils und einer großen Schleifenverstärkung durch geeignete Wahl der Filterstruktur 3 wird eine vollständige Kompensation der Resonanz erreicht (PID-Regelung). Der differenzierende Anteil erzeugt eine Phasenrückdrehung um 90°, welche genutzt werden kann, um das System zu stabilisieren. Dadurch verschwindet die Resonanz vollständig und das typische Noise-Shaping-Verhalten eines Sigma-Delta-Wandlers kommt zum Vorschein, wie dies in Fig. 3 zu erkennen ist.

Durch die Verwendung eines zeitkontinuierlichen Sigma-Delta-Wandlers kann in der vorliegenden Schaltungsanordnung die Leistungsaufnahme in signifikanter Weise reduziert werden. Dies ist möglich, da die bei zeitkontinuierlichen Sigma-Delta-Wandlern zum Einsatz kommende Integratortechnik, wie z.B. RC-Technik, GmC, etc., geringere Bandbreiten für die Operationsverstärker fordert. Demgegenüber muss die Bandbreite und Anstiegsrate der Operationsverstärker bei Einsatz zeitdiskreter Sigma-Delta-Wandler mit SC-Technik sehr groß sein, um den Spannungsspitzen am Eingang folgen zu können. Diese Spitzen entstehen durch das Umladen der Ladungen in den geschalteten Kapazitäten. Der Einsatz von Operationsverstärkern mit sehr großer Bandbreite und Anstiegsrate führt jedoch zu einem deutlich erhöhten Leistungsverbrauch, der bei der vorliegenden Schaltungsanordnung vermieden wird.

Für die zeitkontinuierliche Auswerteschaltung 2 können unterschiedliche Techniken eingesetzt werden. Fig. 4 zeigt in den Teilabbildungen a) und b) zwei Beispiele für derartige Auswerteschaltungen 2.

Das Beispiel der Fig. 4a) basiert auf dem Abgreifen des Sensorsignals von der Mittenelektrode des Sensors 1, der durch die beiden veränderlichen Kondensatoren dargestellt ist. Diese Ausgestaltung bietet den Vorteil, dass nur ein Verstärker 9 für die Auswerteschaltung benötigt wird. Allerdings ist die Erzeugung des Modulationssignals durch die beiden Wechselspannungsquellen 8 kompliziert, da dieses um 180° verschoben sein muss. Weiterhin dürfen durch die Rückkopplung keine zusätzlichen Signale auf die Mittenelektrode des Sensors 1 übertragen werden.

Aus diesem Grund wird ein differentieller Aufbau bevorzugt, wie er in der Fig. 4b) dargestellt ist. Diese Ausgestaltung benötigt nur eine Wechselspannungsquelle 8, die mit der Mittenelektrode des Sensors 1 verbunden ist. Das Sensorsignal wird über die beiden äußeren Elektroden des Sensors 1 mit einem Differenzverstärker 9 abgegriffen.

Als dritte Alternative kann für jede Kapazität des Sensors 1 auch ein eigener Verstärker gewählt werden. Dies führt jedoch zu einer großen Anzahl von Verstärkern und damit zu einer Vergrößerung der Fläche und des Stromverbrauches für die Schaltungsanordnung.

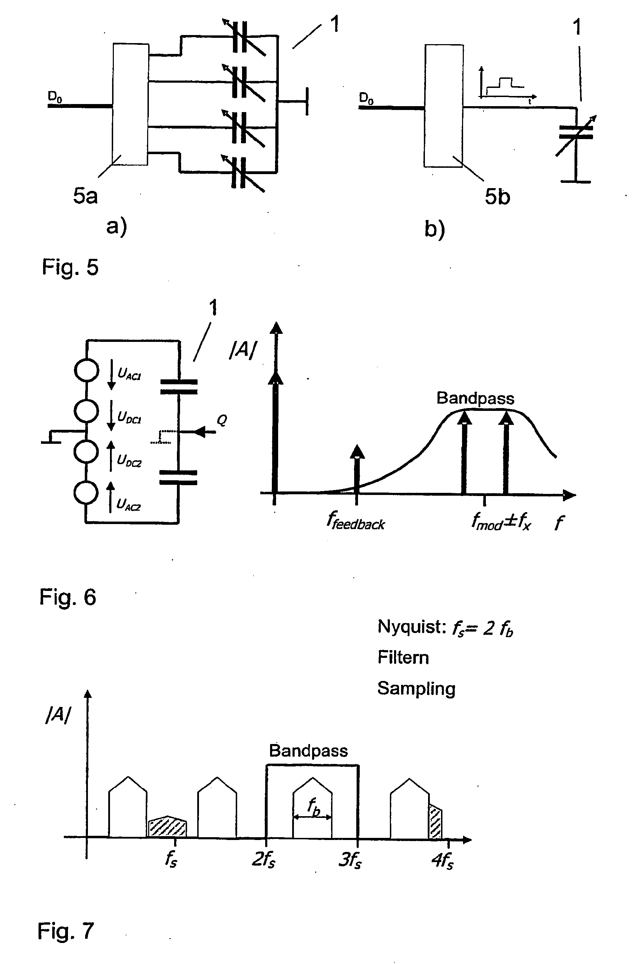

Die Rückkopplung erfolgt kapazitiv über ein pulsweitenmoduliertes Signal, ein 1 Bit- oder Multibit Spannungssignal oder ein 1 Bit- oder Multibit-Ladungssignal. Die Multibit-Rückkopplung kann entweder durch einen speziellen Digital-Analog-Wandler 5b erreicht werden, der eine implizite Linearisierung der Rückkopplungskraft durchführt, oder durch die Verwendung von mehreren Rückkopplungselektroden am Sensor 1, wie dies in der Fig. 5a) dargestellt ist. Diese Figur zeigt einen Multibit Digital-Analog-Wandler 5a, der auf mehrere Elektroden eines entsprechend ausgestalteten Sensors 1 zur Kompensation der Auslenkung der Testmasse wirkt. Fig. 5b) zeigt einen Multibit-Digital-Analog-Wandler 5b, in dem bereits eine implizite Linearisierung der Rückkopplungskraft durchgeführt wird. Dieser Wandler erzeugt ein Rückkopplungssignal das nur auf eine Elektrode des Sensors 1 wirkt.

Fig. 6 zeigt schließlich eine Darstellung, die die Wirkung eines Bandpass Sigma-Delta-Wandlers in der vorliegenden Schaltungsanordnung veranschaulicht. Während des Auslesevorgangs werden hierbei die Sensorsignale zu höheren Frequenzen moduliert. Dies ist im linken Teil der Fig. 6 dargestellt, in der mit U_{DC1/DC2} die Rückkopplungssignale und mit U_{AC1/AC2} die Modulationssignale zum Auslesen des Sensors 1 angegeben sind. Bei den Modulationssignalen handelt es sich in diesem Beispiel um die Wechselspannung der ein oder mehreren Wechselspannungsquellen 8 der Auswerteschaltung 2, wie sie in der Fig. 5 beispielhaft dargestellt ist. Durch diese Modulation zu höheren Frequenzen können Nichtidealitäten des Sigma-Delta-Wandlers bzw. dessen passiver und aktiver Komponenten, die sich als spektrale Anteile bei Gleichstrom darstellen, umgangen werden. Die modulierten Signale werden durch den Bandpass des Sigma-Delta-Wandlers gefiltert, wie dies im rechten Teil der Fig. 6 veranschaulicht ist, in dem fₓ die Signalfrequenz, f_{mod} die Modulationsfrequenz und f_{feedback} die Frequenz der Rückkopplungssignale repräsentiert, mit der der Modulator versucht, die Auslenkung der Testmasse zu kompensieren. Die Rückkopplungssignale müssen hierbei wieder auf die ursprüngliche Frequenz heruntergemischt werden, um das Eingangssignal kompensieren zu können.

Fig. 7 zeigt schließlich die Wirkung einer weiteren Ausgestaltung der vorliegenden Schaltungsanordnung, bei der die Möglichkeit der Unterabtastung bei zeitkontinuierlichen Bandpass Sigma-Delta-Wandlern genutzt wird. Auch hier werden wie beim soeben beschriebenen Bandpass Sigma-Delta-Wandler während des Auslesevorgangs die Signale zu höheren Frequenzen moduliert, um Nichtidealitäten des Sigma-Delta-Wandlers zu umgehen. Die modulierten Signale werden aber dann durch Sub-Nyquist-Sampling während des Sample-Prozesses wieder heruntergemischt und damit in situ die Abtastrate reduziert. Die eingesetzten Analog-Digigal- bzw. Digital-Analog-Wandler sowie andere digitale Komponenten können damit bei einer niedrigen Frequenz arbeiten. In der Fig. 7 sind hierbei die durch den Bandpass-Filter unterdrückten unerwünschten Signale in schraffierter Form dargestellt. Das nicht schraffierte erwünschte Signal zwischen 2fₛ und 3fₛ wird durch den Filter hingegen nicht beeinflusst. Durch die Unterabtastung wird dieses Signal ins Basisband gefaltet. Dies ist durch periodische Wiederholung des Signals in der Fig. 7 angedeutet.

### Bezugszeichenliste

- 1: Kapazitiver Beschleunigungssensor
- 2: Auswerteschaltung
- 3: Filterstruktur
- 4: Quantisierer
- 5: Digital-Analog-Wandler
- 5a: Multibit Digital-Analog-Wandler
- 5b: Multibit Digital-Analog-Wandler mit impliziter Linearisierung.
- 6: Kompensationsschaltung
- 7: Addierer
- 8: Wechselspannungsquelle
- 9: Verstärker

## Patentansprüche

1. Schaltungsanordnung zum Auslesen eines Sensors, die einen Sigma-Delta-Wandler mit zumindest einem Schleifenfilter (3), einem Quantisierer (4) und einem Rückkopplungszweig umfasst, wobei sich in Abhängigkeit von einer auf den Sensor (1) wirkenden Messgröße eine messbare elektrische Eigenschaft des Sensors (1) ändert und der Sensor (1) zwischen dem Rückkopplungszweig und dem Schleifenfilter (3) derart verschaltet ist, dass Rückkopplungssignale des Sigma-Delta-Wandlers im zeitlichen Mittel die Wirkung der Messgröße auf den Sensor (1) kompensieren,
wobei der Sigma-Delta-Wandler ein zeitkontinuierlicher Sigma-Delta-Wandler ist, im Sigma-Delta-Wandler eingesetzte Operationsverstärker eine geringere Bandbreite aufweisen als eine Bandbreite, die bei Nutzung zeitdiskreter Signale bei gleicher Sampling-Frequenz erforderlich ist und eine Auswerteschaltung (2) zur Erzeugung eines elektrischen Sensorsignals für die messbare elektrische Eigenschaft des Sensors (1) vorgesehen ist, wobei die Auswerteschaltung (2) einen zeitlichen Verlauf der messbaren elektrischen Eigenschaft zu höheren Frequenzen moduliert und der Schleifenfilter (3) zur Erzeugung eines Bandpasses bei diesen höheren Frequenzen gewählt ist.

2. Schaltungsanordnung nach Anspruch 1,
**dadurch gekennzeichnet,**
**dass** der Schleifenfilter (3) so gewählt ist, dass über den Rückkopplungszweig eine PI-Regelung erreicht wird.

3. Schaltungsanordnung nach Anspruch 1,
**dadurch gekennzeichnet,**
**dass** der Schleifenfilter (3) so gewählt ist, dass über den Rückkopplungszweig eine PID-Regelung erreicht wird.

4. Schaltungsanordnung nach einem der Ansprüche 1 bis 3, **dadurch gekennzeichnet,**
**dass** im Rückkopplungszweig eine Mischeinrichtung vorgesehen ist, die die Rückkopplungssignale wieder auf Frequenzen des zeitlichen Verlaufs der messbaren elektrischen Eigenschaft heruntermischt.

5. Schaltungsanordnung nach einem der Ansprüche 1 bis 3, **dadurch gekennzeichnet,**
**dass** der Quantisierer (4) zur Unterabtastung des modulierten Sensorsignals ausgebildet ist.

6. Schaltungsanordnung nach Anspruch 4 oder 5,
**dadurch gekennzeichnet,**
**dass** die Auswerteschaltung (2) ein oder mehrere Wechselstromquellen (8) umfasst, über die der zeitliche Verlauf der messbaren elektrischen Eigenschaft des Sensors (1) zu den höheren Frequenzen moduliert wird.

7. Schaltungsanordnung nach einem der Ansprüche 1 bis 6, **dadurch gekennzeichnet,**
**dass** der Sensor (1) ein kapazitiver Sensor ist.

8. Schaltungsanordnung nach einem der Ansprüche 1 bis 7, **dadurch gekennzeichnet,**
**dass** der Sensor (1) ein Beschleunigungssensor mit einer beweglich aufgehängten Testmasse ist, bei dem eine durch Beschleunigung verursachte Lageänderung der Testmasse die messbare elektrische Eigenschaft des Sensors (1) ändert.

9. Schaltungsanordnung nach einem der Ansprüche 1 bis 8, **dadurch gekennzeichnet,**
**dass** im Rückkopplungszweig ein 1-Bit Digital-Analog-Wandler für eine 1-Bit Rückkopplung angeordnet ist.

10. Schaltungsanordnung nach einem der Ansprüche 1 bis 8, **dadurch gekennzeichnet,**
**dass** im Rückkopplungszweig ein Multi-Bit Digital-Analog-Wandler (5) für eine Multi-Bit Rückkopplung angeordnet ist.

11. Verfahren zum Auslesen eines Sensors, bei dem der Sensor (1) zwischen einem Rückkopplungszweig und zumindest einem Schleifenfilter (3) eines Sigma-Delta-Wandlers derart verschaltet wird, dass Rückkopplungssignale des Sigma-Delta-Wandlers im zeitlichen Mittel die Wirkung einer auf den Sensor (1) einwirkenden Messgröße kompensieren,
wobei ein zeitkontinuierlicher Bandpass Sigma-Delta-Wandler eingesetzt wird und im Sigma-Delta-Wandler Operationsverstärker eingesetzt werden, die eine geringere Bandbreite aufweisen als eine Bandbreite, die bei Nutzung zeitdiskreter Signale bei gleicher Sampling-Frequenz erforderlich ist, und wobei ein vom Sensor (1) erhaltenes Sensorsignal vor einer Abtastung zu höheren Frequenzen moduliert wird, die im Bandpass-Bereich des Sigma-Delta-Wandlers liegen.

12. Verfahren nach Anspruch 11,
**dadurch gekennzeichnet,**
**dass** über den Rückkopplungszweig eine PI-Regelung durchgeführt wird.

13. Verfahren nach Anspruch 11,
**dadurch gekennzeichnet,**
**dass** über den Rückkopplungszweig eine PID-Regelung durchgeführt wird.

14. Verfahren nach einem der Ansprüche 11 bis 13,
**dadurch gekennzeichnet,**
**dass** die Rückkopplungssignale im Rückkopplungszweig wieder auf Frequenzen des elektrischen Sensorsignals heruntergemischt werden.

15. Verfahren nach einem der Ansprüche 11 bis 13,
**dadurch gekennzeichnet,**
**dass** das modulierte Sensorsignal anschließend durch Unterabtastung digitalisiert wird.

16. Verfahren nach Anspruch 14 oder 15,
**dadurch gekennzeichnet,**
**dass** die Modulation zu höheren Frequenzen über eine an den Sensor (1) angelegte Wechselspannung erfolgt, mit der der Sensor (1) ausgelesen wird.

17. Verfahren nach einem der Ansprüche 11 bis 16,
**dadurch gekennzeichnet,**
**dass** die Rückkopplung über ein 1-Bit oder Multi-Bit Ladungs- oder Spannungssignal erfolgt.

18. Verfahren nach einem der Ansprüche 11 bis 16,
**dadurch gekennzeichnet, dass** die Rückkopplung über ein pulsweitenmoduliertes Signal erfolgt.

19. Verfahren nach einem der Ansprüche 11 bis 18 zum Auslesen eines kapazitiven Sensors.

20. Verfahren nach einem der Ansprüche 11 bis 19 zum Auslesen eines Beschleunigungssensors mit einer beweglich aufgehängten Testmasse, bei dem eine durch Beschleunigung verursachte Lageänderung der Testmasse eine messbare elektrische Eigenschaft des Sensors (1) ändert.

## Claims

1. A circuit for obtaining sensor readings, which comprises a sigma-delta converter with at least a loop filter (3), a quantizer (4) and a feedback branch, wherein a measurable electrical characteristic of the sensor (1) varies as a function of a measurement variable acting on the sensor (1), and the sensor (1) is connected between the feedback branch and the loop filter (3) in such a manner that feedback signals of the sigma-delta converter, averaged over time, compensate for the effect of the measurement variable on the sensor (1),
wherein the sigma-delta converter is a time-continuous sigma-delta converter, operational amplifiers used in the sigma-delta converter have a smaller bandwidth than that bandwidth which is required when using time-discrete signals at the same sampling frequency, and an evaluation circuit (2) is provided for producing an electrical sensor signal for the measurable electrical characteristic of the sensor (1), wherein the evaluation circuit (2) modulates a temporal profile of the measurable electrical characteristic onto higher frequencies and the loop filler (3) is selected to generate a bandpass filter at these higher frequencies.

2. The circuit according to claim 1,
**characterized in that**
the loop filter (3) is selected such that PI regulation is obtained via the feedback branch.

3. The circuit according to claim 1,
**characterized in that**
the loop filter (3) is selected such that PID regulation is obtained via the feedback branch.

4. The circuit according to any one of claims 1 to 3,
**characterized in that**
a mixer is provided in the feedback branch, which downmixes the feedback signals back to the frequencies of the temporal profile of the measurable electrical characteristic.

5. The circuit according to any one of claims 1 to 3,
**characterized in that**
the quantizer (4) is designed for downsampling the modulated sensor signal.

6. The circuit according to claim 4 or 5,
**characterized in that**
the evaluation circuit (2) comprises one or a plurality of AC power sources (8), via which the temporal profile of the measurable electrical characteristic of the sensor (1) is modulated onto the higher frequencies.

7. The circuit according to any one of claims 1 to 6,
**characterized in that**
the sensor (1) is a capacitive sensor.

8. The circuit according to any one of claims 1 to 7,
**characterized in that**
the sensor (1) is an acceleration sensor with a moveably suspended test mass, in which a change of position of the test mass caused by acceleration changes the measurable electrical characteristic of the sensor (1).

9. The circuit according to any one of claims 1 to 8,
**characterized in that**
a 1-bit digital-analogue converter for providing 1-bit feedback is arranged in the feedback branch.

10. The circuit according to any one of claims 1 to 8,
**characterized in that**
a multi-bit digital-analogue converter (5) is arranged in the feedback branch for providing multi-bit
feedback.

11. A method for obtaining sensor readings, in which the sensor (1) is interconnected between a feedback branch and at least one loop filter (3) of a sigma-delta converter in such a manner that feedback signals of the sigma-delta converter, averaged over time, compensate for the effect of a measurement variable acting on the sensor (1),
wherein a time-continuous band-pass sigma-delta converter is used, and in said sigma-delta converter operational amplifiers are used that have a smaller bandwidth than a bandwidth which is required when using time-discrete signals at the same sampling frequency, and wherein an electrical sensor signal received from the sensor (1) is modulated onto higher frequencies lying in the bandpass-region of the sigma-delta converter before sampling.

12. The method according to claim 11,
**characterized in that**
PI regulation is carried out via the feedback branch.

13. The method according to claim 11,
**characterized in that**
PID regulation is carried out via the feedback branch.

14. The method according to any one of claims 11 to 13,
**characterized in that**
the feedback signals in the feedback branch are downmixed back to frequencies of the electrical sensor signal.

15. The method according to any one of claims 11 to 13,
**characterized in that**
the modulated signal is subsequently digitalized by downsampling.

16. The method according to claim 14 or 15,
**characterized in that**
the modulation onto higher frequencies is carried out using an AC voltage applied to the sensor (1), with which the reading is obtained from the sensor (1).

17. The method according to any one of claims 11 to 16,
**characterized in that**
the feedback is effected by a 1-bit or multi-bit charge signal or voltage signal.

18. The method according to any one of claims 11 to 16,
**characterized in that**
the feedback is effected by a pulse-width modulated signal.

19. The method according to any one of claims 11 to 18 for reading a capacitive sensor.

20. The method according to any of claims 11 to 19 for reading an acceleration sensor with a moveably suspended test mass, in which a change of position of the test mass caused by an acceleration changes a measurable electrical characteristic of the sensor (1).

## Revendications

1. Circuit pour lire un capteur, lequel comprend un convertisseur sigma-delta avec au moins un filtre à boucle (3), un quantificateur (4) et une branche de rétroaction, dans lequel, en fonction d'une grandeur de mesure agissant sur le capteur (1), une propriété électrique mesurable du capteur (1) varie, et le capteur (1) étant monté entre la branche de rétroaction et le filtre à boucle (3) de manière à ce que des signaux de rétroaction du convertisseur sigma-delta compensent en moyenne temporelle l'effet de la grandeur de mesure sur le capteur (1),
le convertisseur sigma-delta étant un convertisseur sigma-delta constant dans le temps, des amplificateurs opérationnels utilisés dans le convertisseur sigma-delta présentant une largeur de bande plus étroite qu'une largeur de bande nécessaire lors de l'utilisation de signaux discrets dans le temps en cas d'une fréquence d'échantillonnage identique, et un circuit d'évaluation (2) étant prévu pour la génération d'un signal de capteur électrique pour la propriété électrique mesurable du capteur (1), le circuit d'évaluation (2) modulant à des fréquences plus élevées une variation dans le temps de la propriété électrique mesurable, et le filtre à boucle (3) étant choisi pour la production d'une bande passante en cas de ces fréquences plus élevées.

2. Circuit selon la revendication 1,
**caractérisé en ce que**
le filtre à boucle (3) est sélectionné de manière à obtenir un réglage PI par l'intermédiaire de la branche de rétroaction.

3. Circuit selon la revendication 1,
**caractérisé en ce que**
le filtre à boucle (3) est sélectionné de manière à obtenir un réglage PID par l'intermédiaire de la branche de rétroaction.

4. Circuit selon l'une des revendications 1 à 3,
**caractérisé en ce qu'**
un dispositif mélangeur est prévu dans la branche de rétroaction, lequel mixe de nouveau les signaux de rétroaction à la baisse à des fréquences de la variation dans le temps des propriétés électriques mesurables.

5. Circuit selon l'une des revendications 1 à 3,
**caractérisé en ce que**
le quantificateur (4) est réalisé pour un sous-balayage du signal de capteur modulé.

6. Circuit selon la revendication 4 ou 5,
**caractérisé en ce que**
le circuit d'évaluation (2) comprend une ou plusieurs sources de courant alternatif (8) par l'intermédiaire desquelles la variation dans le temps de la propriété électrique mesurable du capteur (1) est modulée aux fréquences plus élevées.

7. Circuit selon l'une des revendications 1 à 6,
**caractérisé en ce que**
le capteur (1) est un capteur capacitif.

8. Circuit selon l'une des revendications 1 à 7,
**caractérisé en ce que**
le capteur (1) est un capteur d'accélération avec une masse de test suspendue de manière mobile, dans lequel un changement de position de la masse de test, provoqué par accélération, modifie la propriété électrique mesurable du capteur (1).

9. Circuit selon l'une des revendications 1 à 8,
**caractérisé en ce qu'**
un convertisseur numérique-analogique à 1 bit est disposé dans la branche de rétroaction pour une rétroaction de 1 bit.

10. Circuit selon l'une des revendications 1 à 8,
**caractérisé en ce qu'**
un convertisseur numérique-analogique multi-bits (5) pour une rétroaction multi-bits est disposé dans la branche de rétroaction.

11. Procédé pour lire un capteur, dans lequel le capteur (1) est monté entre une branche de rétroaction et au moins un filtre à boucle (3) d'un convertisseur sigma-delta de manière à ce que des signaux de rétroaction du convertisseur sigma-delta compensent en moyenne temporelle l'action d'une grandeur de mesure agissant sur le capteur (1),
un convertisseur sigma-delta à bande passante constant dans le temps étant utilisé, et des amplificateurs opérationnels étant utilisés dans le convertisseur sigma-delta, lesquels présentent une largeur de bande plus faible qu'une largeur de bande nécessaire lors de l'utilisation de signaux discrets dans le temps en cas de fréquence d'échantillonnage identique, et un signal de capteur obtenu de la part du capteur (1) étant modulé, avant un balayage, à des fréquences plus élevées qui se situent dans la plage de bande passante du convertisseur sigma-delta.

12. Procédé selon la revendication 11,
**caractérisé en ce qu'**
un réglage PI est réalisé via la branche de rétroaction.

13. Procédé selon la revendication 11,
**caractérisé en ce qu'**
un réglage PID est réalisé via la branche de rétroaction.

14. Procédé selon l'une des revendications 11 à 13,
**caractérisé en ce que**
les signaux de rétroaction dans la branche de rétroaction sont de nouveau mixés à la baisse à des fréquences du signal de capteur électrique.

15. Procédé selon l'une des revendications 11 à 13,
**caractérisé en ce que**
le signal de capteur modulé est ensuite numérisé par sous-balayage.

16. Procédé selon la revendication 14 ou 15,
**caractérisé en ce que**
la modulation à des fréquences plus élevées s'effectue grâce à une tension alternative appliquée au capteur (1) au moyen de laquelle le capteur (1) est lu.

17. Procédé selon l'une des revendications 11 à 16,
**caractérisé en ce que**
la rétroaction s'effectue via un signal de charge ou de tension multi-bits ou à 1 bit.

18. Procédé selon l'une des revendications 11 à 16,
**caractérisé en ce que**
la rétroaction s'effectue via un signal à modulation des impulsions en largeur.

19. Procédé selon l'une des revendications 11 à 18 pour la lecture d'un capteur capacitif.

20. Procédé selon l'une des revendications 11 à 19 pour la lecture l'un capteur d'accélération avec une masse de test suspendue de manière mobile, dans lequel un changement de position provoqué par accélération de la masse de test modifie une propriété électrique mesurable du capteur (1).
